# EUROPEAN PATENT SPECIFICATION

(11) **EP 3 252 829 B1**
(45) Date of publication and mention of the grant of the patent: **23.09.2026**
(21) Application number: 16743394.5
(22) Date of filing: 27.01.2016
(51) Int. Cl.: H10K 77/00

(54) **ORGANIC SEMICONDUCTOR ELEMENT**
ORGANISCHES HALBLEITERELEMENT
ÉLÉMENT À SEMI-CONDUCTEUR ORGANIQUE

(30) Priority: 29.01.2015 JP 2015015744
(43) Date of publication of application: 06.12.2017
(73) Proprietor: The University of Tokyo, Tokyo 113-8654 (JP)
(72) Inventor: MATSUI, Hiroyuki, Tokyo 113-8654 (JP); TAKEYA, Junichi, Tokyo 113-8654 (JP)
(74) Representative: Kuhnen & Wacker Patent- und Rechtsanwaltsbüro PartG mbB
(86) International application number: PCT/JP2016/052266
(87) International publication number: WO 2016/121791

(56) References cited:
- WO-A1-2012/165612
- WO-A1-2013/065582
- JP-A- 2011 242 153
- JP-A- 2013 058 680
- JP-A- 2013 159 584
- JP-A- 2014 049 722
- US-A1- 2005 211 973
- ETIENNE MENARD ET AL: "Micro- and Nanopatterning Techniques for Organic Electronic and Optoelectronic Systems", CHEMICAL REVI, AMERICAN CHEMICAL SOCIETY, WASHINGTON, DC, US, vol. 107, 1 January 2007 (2007-01-01), pages 1117 - 1160, XP007911140, DOI: 10.1021/CR050139Y
- HANYING LI ET AL: "High-Mobility Field-Effect Transistors from Large-Area Solution-Grown Aligned C 60 Single Crystals", JOURNAL OF THE AMERICAN CHEMICAL SOCIETY, vol. 134, no. 5, 6 January 2012 (2012-01-06), US, pages 2760 - 2765, XP055502485, ISSN: 0002-7863, DOI: 10.1021/ja210430b
- REESE ET AL: "Organic single-crystal field-effect transistors", MATERIALS TODAY, ELSEVIER, AMSTERDAM, NL, vol. 10, no. 3, 16 February 2007 (2007-02-16), pages 20 - 27, XP005893105, ISSN: 1369-7021, DOI: 10.1016/S1369-7021(07)70016-0

## Description

### Technical Field

The present invention relates to an organic semiconductor element.

### Background

Conventionally, as an organic semiconductor element of this type, there has been proposed an organic semiconductor element in which a compressive stress is applied to a multi-crystal or amorphous organic semiconductor (see Patent Literature 1, for example). In this device, the organic semiconductor is formed as a thin film on a bent substrate by a vapor deposition or a spin coating, and the compressive stress is applied to the organic semiconductor by stretching the bent substrate until the substrate becomes planar. With the compressive stress applied to the organic semiconductor, the carrier mobility of the organic semiconductor is increased.

Further prior art is disclosed in the following documents.

US 2005/0211973 A1 discloses a stressed organic semiconductor. A semiconductor device includes an organic semiconductor material coupled to a substrate at an interface between the two components. The substrate has a first thermal expansion coefficient. The organic semiconductor material has a second thermal expansion coefficient that is different from the first thermal expansion coefficient. A mechanical stress is transferred from the substrate to the organic semiconductor through the interface, the mechanical stress being related to the difference between the first thermal expansion coefficient and the second thermal expansion coefficient.

ETIENNE MENARD ET AL: "Micro- and Nanopatterning Techniques for Organic Electronic and Optoelectronic Systems", CHEMICAL REVI, AMERICAN CHEMICAL SOCIETY, WASHINGTON, DC, US, vol. 107, 1 January 2007 (2007-01-01), pages 1117-1160, XP007911140, DOI: 10.1021 /CR050139Y [retrieved on 2007-11-04] discloses the following: The economics associated with conventional electronics/ optoelectronics and the resulting importance of the lithographic techniques used for those systems both strongly suggest that manufacturing approaches for organic devices will play critical roles in determining the success of the technology and the range of its applications. The patterning techniques presented in this review are diverse in their operational characteristics, their patterning capabilities, and the materials that they can manipulate. Many represent adaptations of mature technologies, such as inkjet, thermal laser transfer, or embossing techniques, that have already been scaled up for manufacturing in other areas. Others are newer and remain in a research exploratory phase. The use of shadow masking for the fabrication of OLED displays represents a good example of the successful transition to manufacturing. More exciting, in terms of novel patterning processes, is the recent emergence of large-area, prototype OLED displays that use active layers formed by inkjet and thermal laser transfer printing. As a benchmark of progress in this area, it is interesting to note that the first liquid crystal prototypes were demonstrated in 1968 with commercial production following in 1987. Polymer-based OLEDs were first reported in 1996 and the first inkjet printed display prototypes, based on these emissive polymers, were demonstrated in 2004. Although much of the work during this development period has focused on the materials and their behavior in active devices, substantial efforts were needed to invent the printing methods needed to pattern the electroluminescent polymers in cost-effective ways. The associated pilot line manufacturing systems, which now exist at large and small companies, suggest that further developed versions of these methods may have some promise for commercial scale production. If these efforts achieve their goal in the next few years, then one could conclude that the speed of development was comparable to that of liquid crystal technologies. Displays, as well as organic solar cells, do not have, however, the demanding resolution and registration requirements (ignoring certain elements such as output couplers and concentrators and, of course, the circuit components of these devices) of organic transistors and circuits. For electronics, the patterning techniques must simultaneously achieve micrometer resolution and registration, at least for the source/ drain level, together with low-cost, large-area operation on plastic substrates. These challenging requirements might be achieved with microcontact printing or imprint lithography or by the combined use of such approaches with inkjet delivery of the active materials. In a particular example, high resolution relief structures or wettability patterns formed with the former techniques could control the movement and position of droplets printed with the latter. In this strategy, the high-resolution methods, which have limited ability to pattern active materials, define critical features (e.g., transistor channel lengths) where resolution is of paramount importance, whereas other methods with lower resolution capabilities but the capacity to pattern active materials form the other elements. An overall approach that mixes and matches different techniques in this manner is attractive because it exploits the various strengths of the different techniques. To date, however, no clearly compelling manufacturing strategy has emerged for organic electronics, in spite of several impressive demonstrations of circuits that involve all or many of the key elements patterned using printing type processes. Benchmarked against inorganic transistor technology, the evolution of organic electronics has been slow: only ~20 years separated the invention of the first inorganic transistor from mass production of medium-scale integrated (MSI) circuits containing hundreds of transistors; but today, ~20 years after the demonstration of the first organic transistor, systems with hundreds of organic transistors have been demonstrated, but the path to mass production is still unclear. The challenges involve mainly (i) developing manufacturing-ready and cost-effective patterning techniques for large-area, low-cost systems while achieving, simultaneously, the necessary resolution and registration on plastic (which is known tobe dimensionally unstable, at the micrometer level, in large-substrate form) and (ii) implementing organic semiconductors, the known versions of which have relatively modest performance and uncertain reliability. These two challenges are strongly linked. For example, a high-performance, reliable materials set would reduce the demands on patterning resolution and enable large-area printed circuits that could compete effectively on the basis of cost and, in some cases, performance with adapted versions of existing electronics technologies. Partly for this reason, a growing amount of research focuses on understanding the upper limits in mobilities of small molecule and polymer semiconductors and, perhaps more important, on developing new classes of "printable" semiconductor materials, such as those based on thin films of carbon nanotubes and inorganic wires, ribbons, sheets, and particles. The former efforts are beginning to identify certain organic systems with interesting performance characteristics (e.g., mobilities in the range of 10-20 cm2/V·s) and the underlying physics that governs charge transport. The latter work is also yielding significant progress, based on strategies that involve "bottom up" growth of wires,377,378 particles or tubes, followed by integration and/or assembly on plastic substrates, as well as "top down" micromachining of similar structures from wafers followed by printing. Such methods can produce bendable transistors on plastic substrates, with mobilities of several hundred cm2N·s and higher and with operating frequencies in the GHz regime using GaAs wires and hundreds of MHz using Si ribbons, even with modest critical dimensions (micrometers). Films of carbon nanotubes, in random networks or aligned arrays, can offer comparable or even better performance, with other interesting attributes such as extreme levels of bendability and optical transparency. At the same time, efforts to integrate large-grained polysilicon on plastic by use of specialized laser annealing procedures applied to solution-deposited silicon precursors are yielding impressive results. Circuits that use these and other high-performance materials can be achieved with greatly reduced requirements on patteming resolution and registration. In many cases, these materials also offer paths to highly robust and reproducible devices, which exploit the decades of research on wafer-based devices that use similar materials sets. The compatibility of the printing techniques reviewed here with these and other materials, as well as the more heavily explored organics, represents a key strength that will enhance their likelihood of evolving into meaningful approaches to manufacturing. In this sense, the development of unconventional patteming techniques for electronics and optoelectronics is becoming a field of its own, as the work broadens from early efforts configured to answer the question, "Now that we have organic electronic materials, can we develop optimized unconventional patteming methods to form circuits with them?", to include a related, but much different question, "Now that we have unconventional patterning techniques, can we develop optimized electronic materials to form circuits with them?"

High-Mobility Field-Effect Transistors from Large-Area Solution-Grown Aligned C₆₀ Single Crystals of Hanying Li, Beryamin C-K. Tee, Jucly J. Chu., Yi Cui, Jong Won Chung, Sang Yoon Lee and Zhenan Bao discloses the following: Field-effect transistors based on single crystals of organic semiconductors have the highest reported charge carrier mobility among organic materials, demonstrating great potential of organic semiconductors [or electronic applications]. However, single-crystal devices are difficult to fabricate. One of the biggest challenges is to prepare dense arrays of single crystals over large-area substrates with controlled alignment. Here, we describe a solution processing method to grow large arrays of aligned C₆₀ single crystals. Our well-aligned C₆₀ single-crystal needles and ribbons show electron mobility as high as 11 cm²v⁻¹s⁻¹.

### Citation List

### Patent Literature

PTL 1: JP2005-166742

### SUMMARY

However, in the above-described organic semiconductor element, since a multi-crystal or amorphous organic semiconductor is used, it is difficult to obtain organic semiconductors having an identical multi-crystal structure or an identical amorphous structure. Because of the difference in the structure, even when organic semiconductors are produced by the same technique and the same compressive stress is applied so that the same strain is given, the organic semiconductors often differ in the carrier mobility, and it is difficult to obtain organic semiconductor elements having uniform property.

A primary object of an organic semiconductor element in the present invention is to provide organic semiconductor elements having uniform property.

For achieving the above-described primary object, an organic semiconductor element in the present invention adopts the following configurations.

The organic semiconductor element of the present invention is defined in independent claims 1 or 2.

In the organic semiconductor element in the present invention, the organic semiconductor is formed as the single-crystal thin film. The crystal structure of a single crystal is determined by the molecules, and therefore, basically, an identical crystal structure is obtained regardless of the production technique. Therefore, when the same strain is given, the same carrier mobility can be obtained. Accordingly, it is possible to obtain organic semiconductor elements having uniform property.

Here, the organic semiconductor may be formed as a thin film whose thickness is 200 nm or less, for example, 100 nm or 50 **nm.** It is preferable that the strain to be given to the organic semiconductor be in a range of 10% or less in a compression direction. Further, as the organic semiconductor, the organic semiconductor is composed of a polycyclic aromatic compound with four or more rings, or a polycyclic compound with four or more rings including at least one unsaturated five-membered heterocyclic compound and a plurality of benzene rings.

In the organic semiconductor element in the present invention, the organic semiconductor may be kept in a state where a predetermined strain is applied in a movement direction of carriers. That is, the organic semiconductor is used while the carrier mobility is fixed in the state where the predetermined strain is applied. By using such an organic semiconductor, it is possible to obtain various semiconductor devices.

In the organic semiconductor element in the present invention, the organic semiconductor element may be operated based on mobility of carriers when a predetermined strain as a standard is given to the organic semiconductor and carrier mobility when a different strain from the predetermined strain is given to the organic semiconductor. Thereby, it is possible to use the organic semiconductor element as a sensor device.

### Brief Description of Drawings

[Figure 1] Figure 1 is an explanatory diagram showing an exemplary configuration of an organic semiconductor element 20 according to a first embodiment of the present invention;
[Figure 2] Figure 2 is an explanatory diagram showing an example of how an organic semiconductor layer 30 is formed;
[Figure 3] Figure 3 is a schematic diagram schematically showing the view of the crystal structure of the organic semiconductor layer 30, as viewed from the b-axis direction;
[Figure 4] Figure 4 is a schematic diagram schematically showing the view of the crystal structure of the organic semiconductor layer 30, as viewed from the a-axis direction;
[Figure 5] Figure 5 is an explanatory diagram showing a relation between mobility of carriers and magnitude of a strain in the organic semiconductor layer 30;
[Figure 6] Figure 6 is a schematic diagram schematically showing how molecules vibrate before and after a compressive stress is applied to a single-crystal organic semiconductor;
[Figure 7] Figure 7 is an explanatory diagram showing an exemplary configuration of an organic semiconductor element 120 according to a second embodiment of the present invention; and
[Figure 8] Figure 8 is an explanatory diagram showing an exemplary formation method for an organic semiconductor layer 130.

### Detailed Description of Embodiments

The following describes some aspects of the invention with reference to embodiment.

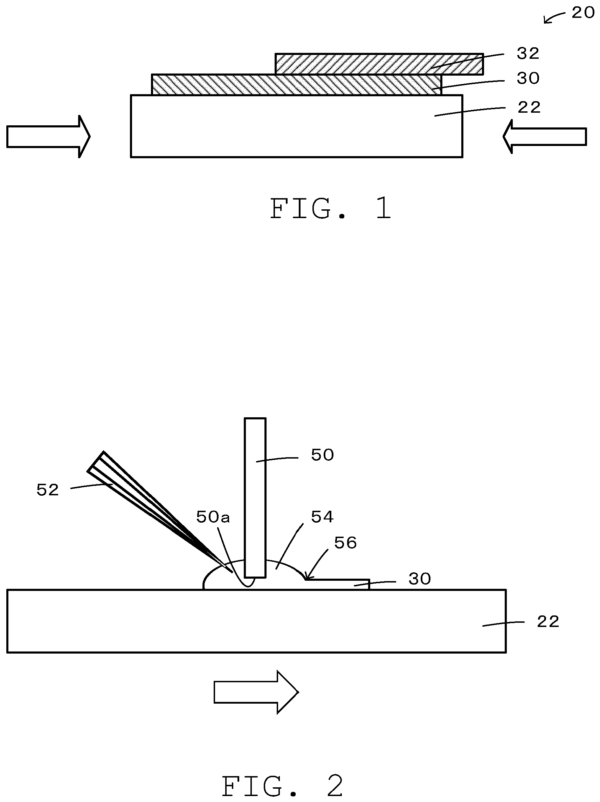

Figure 1 is an explanatory diagram showing an exemplary configuration of an organic semiconductor element 20 that functions as a strain sensor according to a first embodiment of the present invention. The organic semiconductor element 20 includes a substrate 22, an organic semiconductor layer 30 formed on the substrate 22, and two gauge leads 32 formed on the organic semiconductor layer 30 (one of the two gauge leads 32 is not illustrated).

The substrate 22 is formed of a plastic (for example, polyethylene naphthalate), such that the thickness is 50 µm to 10 mm, for example, 100 µm to 200 µm.

The organic semiconductor layer 30 is formed such that the thickness is 200 nm or less, for example, 100 nm or 50 nm, as a single-crystal thin film of an organic semiconductor (for example, 3,11-didecyldinaphto [2,3-d:2',3'-d']benzo [1,2-b:4,5-b']dithiophene (C10-DNBDT) having a structure shown in the following Formula (1)).

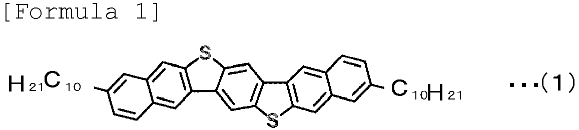

Here, a formation method for the organic semiconductor layer 30 will be described. Figure 2 is an explanatory diagram showing an example of how the organic semiconductor layer 30 is formed. First, a blade 50 is arranged above the substrate 22, so as to be nearly perpendicular to the substrate 22. At this time, the blade 50 is arranged such that the distance between the substrate 22 and a tip 50a of the blade 50 is a predetermined distance (for example, 200 µm) that is greater than the thickness of the organic semiconductor layer 30 to be formed. Then, while a solution 54 in which the organic semiconductor is dissolved in an aromatic compound (for example, o-dichlorobenzene) as a solvent is supplied to the gap between the substrate 22 and the tip 50a of the blade 50 from the left side in Figure 2 using a solution supply pipe 52, the substrate 22 is slowly moved in the right direction in the figure. Thereby, the solvent of the solution 54 at a portion away from the tip 50a of the blade 50 evaporates, so that the organic semiconductor layer 30 is formed as a single-crystal thin film. At this time, by matching the movement speed of the substrate 22 with the growth speed of the single crystal, it is possible to grow the single crystal from a growth point 56 in Figure 2, such that the single crystal has a uniform thickness. Here, in the embodiment, the substrate 22 is moved in the right direction in the figure, but the blade 50 and the solution supply pipe 52 may be moved instead of the movement of the substrate 22.

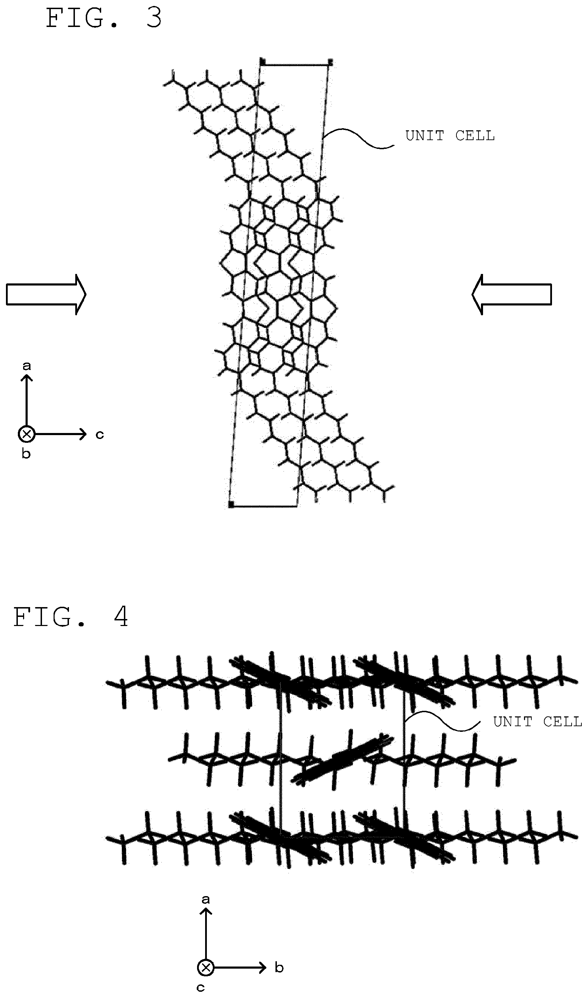

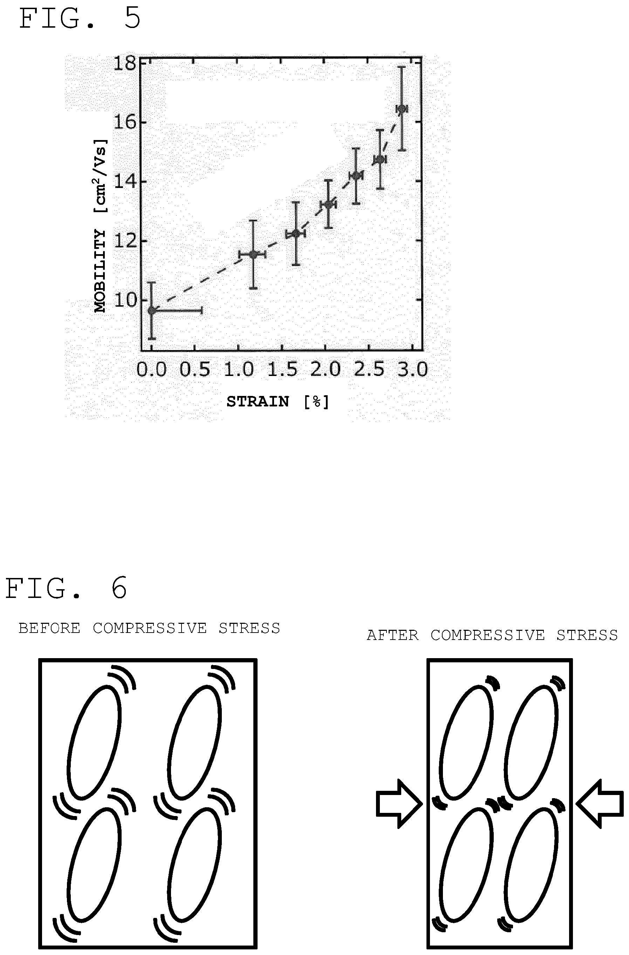

Figure 3 is a schematic diagram schematically showing the view of the crystal structure of the organic semiconductor layer 30, as viewed from the b-axis direction, Figure 4 is a schematic diagram schematically showing the view of the crystal structure of the organic semiconductor layer 30, as viewed from the a-axis direction, and Figure 5 is an explanatory diagram showing a relation between carrier mobility and magnitude of a strain in the organic semiconductor layer 30. In Figures 3 and 4, the three crystal axes (the a-axis, the b-axis and the c-axis) are shown by arrows, and a unit cell is surrounded by a quadrangle. In the organic semiconductor layer 30, for example, when a compressive stress is applied in the direction (the direction shown by the broad arrows in Figure 3) parallel to the c-axis in the crystal structure of the organic semiconductor and a strain is given to the organic semiconductor layer 30, the carrier mobility changes depending on the magnitude of the given strain, as shown in Figure 5. The carrier mobility is determined depending on the magnitude of the strain to be given, and increases as the strain to be given increases. For example, the carrier mobility when the strain is 3% is 16.5 [cm²/(V·s)], which is 1.7 times the carrier mobility when the strain is 0%. Generally, multi-crystal organic semiconductors differ in crystal structure, depending on the formation technique. Therefore, even when the same compressive stress is applied and the same strain is given, it is not possible to obtain the same carrier mobility. In contrast, in single-crystal organic semiconductors, the crystal structure is determined by the molecule. Therefore, basically, an identical crystal structure is obtained regardless of the formation technique, and it is possible to obtain the same carrier mobility when the same compressive stress is applied and the same strain is given. Therefore, the single-crystal organic semiconductors have uniform property with respect to the strain. As the reason for the increase in the carrier mobility, the following reason is conceivable. Figure 6 is a schematic diagram schematically showing how molecules vibrate before and after a compressive stress is applied to the single-crystal organic semiconductor. When the compressive stress is applied to the single-crystal organic semiconductor, it is thought that a strain occurs to the crystal, molecules come closer to each other and the movement of the carrier in the organic semiconductor becomes easier so that the carrier mobility increases. Further, when molecules come closer to each other, the vibration of molecules becomes smaller. Therefore, it is thought that after the compressive stress is applied, as illustrated, the vibration of molecules becomes smaller, the movement of the carrier in the organic semiconductor becomes easier and the carrier mobility increases, compared to before the compressive stress is applied. Furthermore, the distance among molecules becomes closer as the strain to be given to the crystal increases, and therefore, the carrier mobility increases as the strain to be given to the crystal increases. Thus, the single-crystal organic semiconductor has a property of increasing the carrier mobility as the strain to be given increases, and this property is consistent regardless of the formation technique for the organic semiconductor. In the embodiment, since the organic semiconductor layer 30 is formed as the single-crystal thin film, the organic semiconductor layer 30 can have uniform property with respect to the strain (the property of increasing the carrier mobility as the strain to be given increases).

In the organic semiconductor element 20 configured in this way, the magnitude of the strain of an object is detected, in the following procedure. First, a predetermined voltage is applied to the gauge leads 32 in a state where the substrate 22 sticks with the object to be detected. When the strain of the object to be detected changes, the stress to be applied to the organic semiconductor layer 30 together with the substrate 22 changes, and the strain to be given to the organic semiconductor layer 30 changes. When the strain to be given to the organic semiconductor layer 30 changes, the carrier mobility in the organic semiconductor layer 30 changes depending on the magnitude of the strain, and the gauge current to flow through the gauge leads 32 changes. In the organic semiconductor element 20, by measuring the change in the gauge current, it is possible to measure the magnitude of the strain of the object to be detected. Further, the organic semiconductor layer 30, which is formed as the single-crystal thin film, has uniform property with respect to the strain, and therefore, it is possible to provide strain sensors having uniform property.

According to the above-described organic semiconductor element 20 in the first embodiment that functions as a strain sensor device, since the organic semiconductor layer 30 is formed as the single-crystal thin film, it is possible to measure the magnitude of the strain of the detection target. Further, since the organic semiconductor layer 30 is formed as the single-crystal thin film, it is possible to obtain the same carrier mobility when the same strain is given, and it is possible to provide strain sensors having uniform property.

In the first embodiment, the organic semiconductor element 20 functions as a strain sensor. However, the organic semiconductor element 20 is not limited to elements that function as a strain sensor in this way, and may be used as any element that operates based on the carrier mobility when the strain changes (the carrier mobility when a predetermined strain as the standard is given and the carrier mobility when a different strain from the predetermined strain is given), as exemplified by a pressure sensor that detects the pressure given to a pressure sensitive part, and a temperature sensor that detects temperature. For example, in the case of the use as a pressure sensor, the organic semiconductor element may be stuck to a sheet, and based on the current (the carrier mobility) that flows when the strain of the organic semiconductor element changes by the press of the sheet, the pressure given to the sheet may be detected. Further, in the case of the use as a temperature sensor, the organic semiconductor element may be bonded to metals having different thermal expansion coefficients similarly to a bi-metal, and based on the current (the carrier mobility) when the strain of the organic semiconductor element changes due to the difference in thermal expansion coefficient caused by the change in temperature, the temperature may be detected.

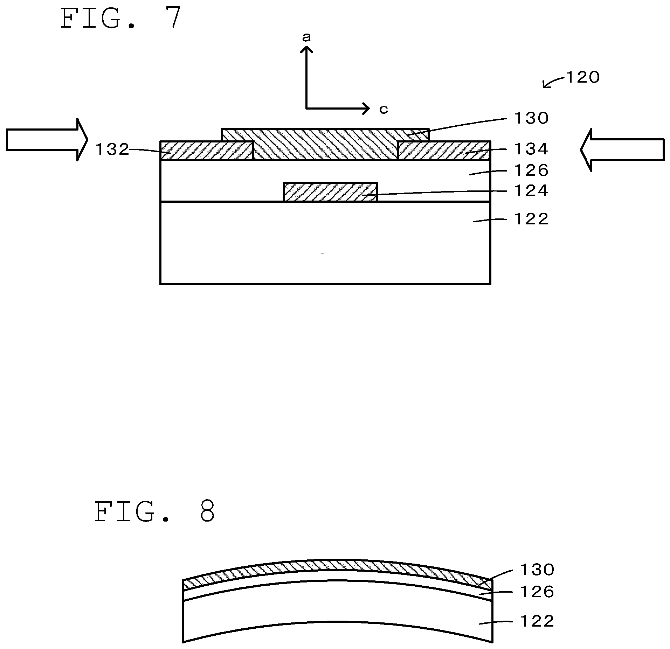

Next, an organic semiconductor element 120 in a second embodiment that functions as a transistor will be described. Figure 7 is an explanatory diagram showing an exemplary configuration of the organic semiconductor element 120 according to the second embodiment of the present invention. The organic semiconductor element 120, which is configured as a top contact-bottom gate type field-effect transistor, includes a substrate 122, a gate electrode 124 formed on a predetermined region of the substrate 122, a gate insulating film 126 formed on the substrate 122 and the gate electrode 124, an organic semiconductor layer 130 formed on the gate insulating film 126 so as to be positioned above the gate electrode 124, and a source electrode 132 and drain electrode 134 formed on the gate insulating film so as to be positioned on both sides of the organic semiconductor layer 130.

The substrate 122 is formed of a plastic (for example, polyethylene naphthalate), such that the thickness is 50 µm to 10 mm, for example, 100 µm to 200 µm.

The gate electrode 124, the source electrode 132 and the drain electrode 134 are formed of a metal material such as gold. The gate electrode 124 is formed such that the thickness is 50 nm or less, for example, 40 nm or 30 nm. The source electrode 132 and the drain electrode 134 are formed such that the thickness is 50 nm or less, for example, 40 nm or 30 nm.

The gate insulating film 126 is formed of an insulating material (for example, polymethyl methacrylate), such that the thickness is 200 nm or less, for example, 150 nm or 100 nm.

The organic semiconductor layer 130 is formed such that the thickness is 200 nm or less, for example, 100 nm or 50 nm, as a single-crystal thin film of an organic semiconductor having the above-described structure shown in Formula (1). The organic semiconductor layer 130 is formed such that the c-axis of the crystal axes in the crystal structure shown in Figure 3 is parallel to the orientation of a channel to be formed, and is kept in a state where a predetermined strain is applied by applying a compressive stress in the c-axis direction. Here, the "predetermined strain" only needs to be a strain by which the organic semiconductor layer 130, the substrate 122 or the gate insulating film 126 is not broken, and in the embodiment, a strain of 10% or less in the compression direction, for example, a strain of 3% in the compression direction can be used.

Here, a formation method for the organic semiconductor layer 130 will be described. Figure 8 is an explanatory diagram showing an exemplary formation method for the organic semiconductor layer 130. First, as illustrated, a single-crystal thin film of the organic semiconductor (the organic semiconductor layer 30) is formed in the right-left direction in the figure, in a state where the substrate 122 having the gate insulating film 126 formed is bent. Thereafter, the substrate 122 is stretched until the substrate 122 becomes planar, and the compressive stress is applied to the thin film. Thereby, the organic semiconductor layer 130 kept in the state where the predetermined strain is applied is formed. As the method for keeping the organic semiconductor layer 130 in a state where a predetermined strain is applied, other than the method exemplified in Figure 8, it is allowable to use another method such as a method of forming a single-crystal thin film of the organic semiconductor in a state where the substrate 122 is heated and is thermally expanded and thereafter thermally contracting the substrate 122 at normal temperature.

Since the organic semiconductor layer 130 is formed as the single-crystal thin film in this way, it is possible to obtain the same carrier mobility when the same compressive stress is applied to and the same strain is given to the organic semiconductor layer 130. Accordingly, the organic semiconductor layer 130 can have uniform property with respect to the strain.

The organic semiconductor element 120 configured in this way operates as a transistor, when a channel is formed in the organic semiconductor layer 130 by applying voltages for operation to the gate electrode 124, the source electrode 132 and the drain electrode 134 respectively. The organic semiconductor layer 130, which is formed as the single-crystal thin film, has uniform property with respect to the strain, and therefore, it is possible to provide transistors having uniform property. Further, since the organic semiconductor layer 130 is kept in the state where the strain is applied, the carrier mobility is higher compared to when the strain is not applied. Therefore, it is possible to make a larger current flow between the source electrode 132 and the drain electrode 134, and it is possible to provide a transistor having a higher drive power.

According to the above-described organic semiconductor element 120 in the second embodiment that functions as a transistor, since the organic semiconductor layer 130 is formed as the single-crystal thin film, it is possible to provide a transistor having a high drive power. Further, since the organic semiconductor layer 130 is formed as the single-crystal thin film, it is possible to obtain the same carrier mobility when the same strain is given, and it is possible to provide transistors having uniform property.

In the second embodiment, the organic semiconductor element 120 is configured as a top contact-bottom gate type field-effect transistor, but may be configured as any type of transistor that can be formed on an inorganic semiconductor such as silicon and gallium nitride, as exemplified by a top contact-top gate type field-effect transistor. Further, the organic semiconductor element is not limited to such transistor, and may be used as any element that can be kept in a state where a predetermined strain is applied in the movement direction of the carrier.

In the organic semiconductor elements 20, 120 in the first and second embodiments, the organic semiconductor layers 30, 130 are formed of the organic semiconductor having the above-described structure in Formula (1). However, as the organic semiconductor, for example, a polycyclic aromatic compound with four or more rings or a polycyclic compound with four or more rings including one or a plurality of unsaturated five-membered heterocyclic compounds and a plurality of benzene rings can be used. For example, any structure in the following Formula (2) to Formula (14) may be adopted. In Formula (2) to Formula (14), as R, a straight alkyl, a branched alkyl, a fluorinated straight/branched alkyl, triisopropylsilylethynyl, phenyl or the like can be used.

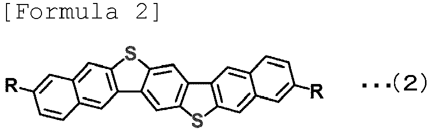

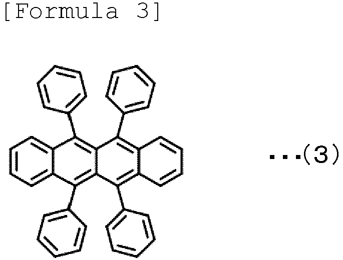

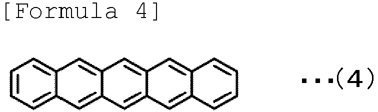

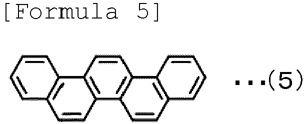

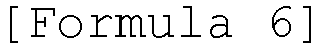

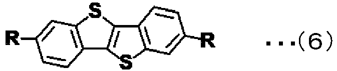

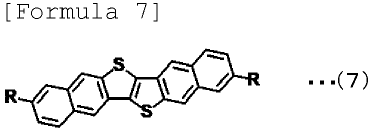

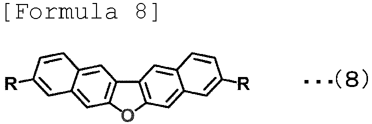

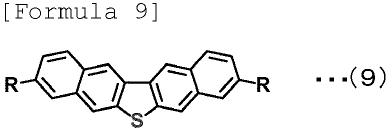

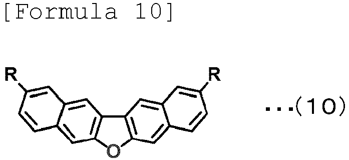

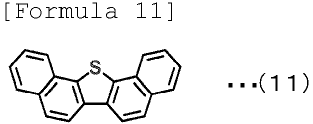

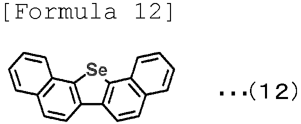

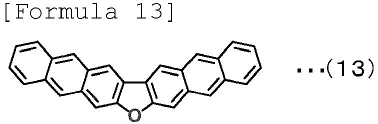

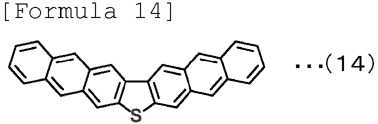

### INDUSTRIAL APPLICABILITY

The present invention can be utilized in production industries for an organic semiconductor element, and the like.

## Claims

1. An organic semiconductor element (20) comprises an organic semiconductor (30), wherein
the organic semiconductor is formed as a thin film of single-crystal composed of a polycyclic compound with four or more rings including at least one unsaturated five membered heterocyclic compound and a plurality of benzene rings, and
the organic semiconductor has a carrier mobility of greater than 9.7 cm²/Vs when a strain is applied, wherein
the organic semiconductor element is configured to operate based on carrier mobility when the strain is given to at least the organic semiconductor, wherein
the carrier mobility increases when the strain increases,
the strain is a compressive stress, and
the organic semiconductor is kept in a state where a strain is applied in a movement direction of carriers.

2. An organic semiconductor element (20) comprises an organic semiconductor (30), wherein
the organic semiconductor is formed as a thin film of single-crystal composed of a polycyclic compound with four or more rings including at least one unsaturated five membered heterocyclic compound and a plurality of benzene rings, and
the organic semiconductor has a carrier mobility of greater than 9.7 cm²/Vs when a strain is applied,
the organic semiconductor element is configured to operate based on carrier mobility when the strain is applied in only one direction to the organic semiconductor and a strain given to at least the organic semiconductor changes, and
wherein the carrier mobility increases when the strain increases,
and the strain is a compressive stress.

3. The organic semiconductor element according to claim 1, wherein
the organic semiconductor is kept in a state where a predetermined strain is applied in a movement direction of carriers.

4. The organic semiconductor element according to claim 3, further comprising:
a gate electrode (124);
a source electrode (132); and
a drain electrode (134); wherein
the gate is arranged in a-axis direction of the crystal axes of the organic semiconductor via a gate insulating film, and
the source electrode and drain electrode are arranged so as to be positioned on both sides of the organic semiconductor in the c-axis direction.

5. The organic semiconductor element according to claim 1, wherein
the organic semiconductor element operates based on carrier mobility when a predetermined strain as a standard is given to the organic semiconductor and carrier mobility when a different strain from the predetermined strain is given to the organic semiconductor.

6. The organic semiconductor element according to any one of claims 1 to 5, wherein
the organic semiconductor is formed as a thin film having a thickness of 200 nm or less.

7. The organic semiconductor element according to any one of claims 1 to 5, wherein
the strain to be given to the organic semiconductor is in a range of 10% or less in a compression direction.

## Patentansprüche

1. Organisches Halbleiterelement (20) umfasst einen organischen Halbleiter (30), wobei
der organische Halbleiter als Dünnfilm aus Einkristall ausgebildet ist, der aus einer polyzyklischen Verbindung mit vier oder mehr Ringen zusammengesetzt ist, einschließlich mindestens einer ungesättigten fünfgliedrigen heterozyklischen Verbindung und einer Mehrzahl von Benzolringen, und
der organische Halbleiter eine Ladungsträgerbeweglichkeit von größer als 9,7 cm2/Vs aufweist, wenn eine Belastung angelegt wird, wobei
das organische Halbleiterelement dazu konfiguriert ist, auf Grundlage der Ladungsträgerbeweglichkeit zu arbeiten, wenn die Belastung zumindest dem organischen Halbleiter zugeführt wird, wobei
die Ladungsträgerbeweglichkeit zunimmt, wenn die Belastung zunimmt,
die Belastung eine Druckbelastung ist, und
der organische Halbleiter in einem Zustand gehalten wird, in dem eine Belastung in einer Bewegungsrichtung der Ladungsträger angelegt wird.

2. Organisches Halbleiterelement (20) umfasst einen organischen Halbleiter (30), wobei
der organische Halbleiter als Dünnfilm aus Einkristall ausgebildet ist, der aus einer polyzyklischen Verbindung mit vier oder mehr Ringen zusammengesetzt ist, einschließlich mindestens einer ungesättigten fünfgliedrigen heterozyklischen Verbindung und einer Mehrzahl von Benzolringen, und
der organische Halbleiter eine Ladungsträgerbeweglichkeit von größer als 9,7 cm2/Vs aufweist, wenn eine Belastung angelegt wird,
das organische Halbleiterelement dazu konfiguriert ist, auf Grundlage der Ladungsträgerbeweglichkeit zu arbeiten, wenn die Belastung nur in einer Richtung an den organischen Halbleiter angelegt wird und sich die zumindest dem organischen Halbleiter zugeführte Belastung ändert, und
wobei die Ladungsträgerbeweglichkeit zunimmt, wenn die Belastung zunimmt, und die Belastung eine Druckbelastung ist.

3. Organische Halbleiterelement gemäß Anspruch 1, wobei
der organische Halbleiter in einem Zustand gehalten wird, in dem eine vorbestimmte Belastung in einer Bewegungsrichtung der Ladungsträger angelegt wird.

4. Organische Halbleiterelement gemäß Anspruch 3, ferner umfassend:
eine Gate-Elektrode (124);
eine Source-Elektrode (132); und
eine Drain-Elektrode (134), wobei
das Gate in a-Achsenrichtung der Kristallachsen des organischen Halbleiters über einen Gate-Isolierfilm angeordnet ist, und
die Source-Elektrode und die Drain-Elektrode so angeordnet sind, dass sie auf beiden Seiten des organischen Halbleiters in c-Achsenrichtung positioniert sind.

5. Organische Halbleiterelement gemäß Anspruch 1, wobei
das organische Halbleiterelement auf Grundlage der Ladungsträgerbeweglichkeit arbeitet, wenn dem organischen Halbleiter eine vorbestimmte Belastung als Standard zugeführt wird und wenn dem organischen Halbleiter eine von der vorbestimmten Belastung verschiedene Belastung zugeführt wird.

6. Organische Halbleiterelement gemäß einem beliebigen der Ansprüche 1 bis 5, wobei
der organische Halbleiter als Dünnfilm mit einer Dicke von 200 nm oder weniger ausgebildet ist.

7. Organische Halbleiterelement gemäß einem beliebigen der Ansprüche 1 bis 5, wobei
die dem organischen Halbleiter zuzuführende Belastung in einer Kompressionsrichtung in einem Bereich von 10 % oder weniger liegt.

## Revendications

1. Un élément semi-conducteur organique (20) comprend un semi-conducteur organique (30), dans lequel
le semi-conducteur organique est formé sous la forme d'un film mince monocristallin composé d'un composé polycyclique comportant au moins quatre cycles, comprenant au moins un composé hétérocyclique insaturé à cinq membres et une pluralité de cycles benzéniques, et
le semi-conducteur organique présente une mobilité des porteurs supérieure à 9,7 cm²/Vs lorsqu'une contrainte lui est appliquée, dans lequel
l'élément semi-conducteur organique est configuré pour fonctionner sur la base de la mobilité des porteurs lorsqu'une contrainte est appliquée au moins au semi-conducteur organique, dans lequel
la mobilité des porteurs augmente lorsque la contrainte augmente,
la contrainte est une contrainte de compression, et
le semi-conducteur organique est maintenu dans un état où une contrainte est appliquée dans la direction de déplacement des porteurs.

2. Un élément semi-conducteur organique (20) comprend un semi-conducteur organique (30), dans lequel
le semi-conducteur organique est formé sous la forme d'un film mince monocristallin composé d'un composé polycyclique comportant au moins quatre cycles, comprenant au moins un composé hétérocyclique insaturé à cinq membres et une pluralité de cycles benzéniques, et
le semi-conducteur organique présente une mobilité des porteurs supérieure à 9,7 cm²/Vs lorsqu'une contrainte est appliquée,
l'élément semi-conducteur organique est configuré pour fonctionner sur la base de la mobilité des porteurs lorsque la contrainte est appliquée dans une seule direction au semi-conducteur organique et que la contrainte exercée sur au moins le semi-conducteur organique varie, et
dans lequel la mobilité des porteurs augmente lorsque la contrainte augmente, et la contrainte est une contrainte de compression.

3. L'élément semi-conducteur organique selon la revendication 1, dans lequel
le semi-conducteur organique est maintenu dans un état dans lequel une contrainte prédéterminée est appliquée dans une direction de déplacement des porteurs.

4. L'élément semi-conducteur organique selon la revendication 3, comprenant en outre :
une électrode de grille (124) ;
une électrode de source (132) ; et
une électrode de drain (134), dans lequel
la grille est disposée dans la direction de l'axe a des axes cristallins du semi-conducteur organique par l'intermédiaire d'un film isolant de grille, et
l'électrode de source et l'électrode de drain sont disposées de manière à être positionnées de part et d'autre du semi-conducteur organique dans la direction de l'axe c.

5. L'élément semi-conducteur organique selon la revendication 1, dans lequel
l'élément semi-conducteur organique fonctionne en s'appuyant sur la mobilité des porteurs lorsqu'une contrainte prédéterminée est appliquée au semi-conducteur organique à titre de référence, et sur la mobilité des porteurs lorsqu'une contrainte différente de la contrainte prédéterminée est appliquée au semi-conducteur organique.

6. L'élément semi-conducteur organique selon l'une quelconque des revendications 1 à 5, dans lequel
le semi-conducteur organique est formé sous la forme d'un film mince ayant une épaisseur de 200 nm ou moins.

7. L'élément semi-conducteur organique selon l'une quelconque des revendications 1 à 5, dans lequel
la contrainte à appliquer au semi-conducteur organique est comprise dans une plage de 10 % ou moins dans une direction de compression.
